# FASCICULE DE BREVET EUROPEEN

(11) **EP 3 518 241 B1**
(45) Date de publication et mention de la délivrance du brevet: **05.08.2020**
(21) Numéro de dépôt: 19152988.2
(22) Date de dépôt: 22.01.2019
(51) Int. Cl.: G11C 11/419, G11C 7/08

(54) **MÉMOIRE SRAM À DÉCLENCHEMENT DE FIN DE LECTURE AMÉLIORÉE**
SRAM-SPEICHER MIT VERBESSERTER AUSLÖSUNG DES BEENDENS DES WIEDERGABEVORGANGS
SRAM MEMORY WITH IMPROVED TRIGGERING OF END OF READING

(30) Priorité: 24.01.2018 FR 1850542
(43) Date de publication de la demande: 31.07.2019
(73) Titulaire: Commissariat à l'énergie atomique et aux énergies alternatives, 75015 Paris (FR)
(72) Inventeur: MAKOSIEJ, Adam, 38000 GRENOBLE (FR); ROYER, Pablo, 38000 GRENOBLE (FR)
(74) Mandataire: Brevalex

(56) Documents cités:
- JP-A- 2007 220 259
- US-A1- 2006 083 091
- US-B1- 9 858 988

## Description

### DOMAINE TECHNIQUE ET ART ANTÉRIEUR

La présente invention se rapporte au domaine des mémoires de type SRAM (SRAM pour « Static Random Access Memory » ou mémoire vive statique à accès aléatoire), et concerne en particulier celui de la gestion des opérations de lecture.

La présente invention met en œuvre un circuit permettant de générer un signal indicateur de fin d'une phase particulière d'une opération de lecture et s'adapte tout particulièrement aux dispositifs fonctionnant à basse tension ou dans lesquels une modulation de tension d'alimentation (en anglais « supply voltage scaling ») est mise en œuvre au cours des différentes phases de fonctionnement de la mémoire.

Dans les mémoires SRAM, une synchronisation optimale des différentes phases d'une opération de lecture est particulièrement importante à la fois pour assurer une vitesse élevée et un temps d'accès réduit tout en évitant des erreurs de lecture, en particulier en présence de variations temporelles ou spatiales d'un endroit à l'autre de la mémoire.

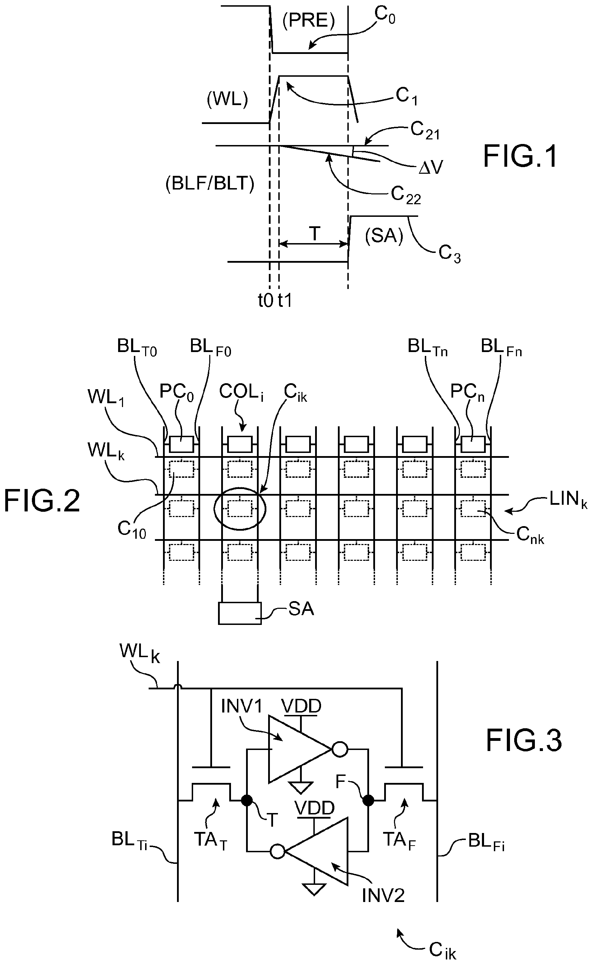

La figure 1 représente, par le biais d'un exemple de chronogramme, une séquence de différentes phases d'une opération de lecture dans une mémoire SRAM conventionnelle. On suppose ici que les signaux sont actifs à l'état haut.

Les lignes de bits sont typiquement pré-chargées à un même potentiel, par exemple un potentiel d'alimentation de VDD par le biais de circuits de pré-charge.

Dans un premier temps to, on désactive la pré-charge (changement d'état de la courbe C₀) des lignes de bit, puis, on active une ligne de mot donnée (changement d'état de la courbe Ci), ce qui permet de sélectionner une ligne de cellules et d'accéder aux nœuds de stockage d'informations.

En fonction de l'information logique stockée, une des lignes parmi une ligne de bit et une ligne de bit complémentaire se décharge (courbe C₂₂ décroissante) et on attend ensuite une durée T donnée pour qu'une différence de tension suffisante ΔV s'établisse entre la ligne de bit et la ligne de bit complémentaire, afin que cette différence de tension puisse être transformée par un amplificateur de lecture (« sense amplifier » selon la terminologie anglo-saxonne) en un signal représentatif d'une information logique stockée dans la cellule. Après cette phase particulière de durée T l'amplificateur de lecture est activé (changement d'état courbe C₃). La fin de l'opération de lecture (changement d'état courbe C₁) étant marquée par une désactivation de la ligne de mot donnée.

La durée T de la phase entre l'instant d'activation de la ligne de mot et l'instant d'activation de l'amplificateur de lecture peut varier, en fonction de la température, de l'emplacement de la cellule que l'on accède en lecture du fait de variations de procédé de fabrication se traduisant par des capacités différentes par exemple d'une ligne de bit à l'autre, ainsi qu'au cours de la durée de vie de la mémoire. Par ailleurs, elle varie en fonction des potentiels mis en œuvre notamment de pré-charge.

Une optimisation de cette durée T est nécessaire. Si l'amplificateur de lecture est déclenché trop tôt, on risque une lecture erronée de l'information stockée mais un déclenchement trop tardif conduit à augmenter le temps d'accès et à générer une consommation inutile.

Cette optimisation s'avère difficile à mettre en œuvre d'autant que pour les dispositifs mémoire SRAM standard, on vise généralement un haut rendement qui peut être de 6σ (σ étant un écart type) et correspondre approximativement à 2 cellules défectueuses sur un milliard.

Le document US 9 858 988 B1 présente une mémoire de type SRAM comprenant une pluralité de cellules de mémoire, une ligne de mots couplée à la pluralité de cellules de mémoire, un amplificateur de détection couplé à l'une de la pluralité de cellules de mémoire, et un circuit de synchronisation configuré pour activer l'amplificateur de détection.

Le document « Low Power and Reliable SRAM Memory Cell and Array Design », de Ishibashi et al, Springer Series in Advanced Micro-electronics, 2011 présente un exemple de dispositif SRAM dans lequel la fin d'une opération de lecture dépend d'un temps nécessaire à la décharge d'une ligne de bit factice reliée à une colonne de cellules factices ajoutées en périphérie du plan matriciel contenant l'ensemble des cellules de mémorisation.

Cette solution est efficace dans la mesure notamment où elle tient compte des caractéristiques de cellules factices qui ont une configuration et donc un comportement semblable à celui de cellules de mémorisation du plan mémoire. Cette solution a toutefois tendance à accroitre l'encombrement global du dispositif mémoire.

Par ailleurs, l'optimisation de la durée T précitée s'avère plus ardue pour les dispositifs fonctionnant à basse tension, ou dans lesquels un ajustement de la tension d'alimentation est mis en œuvre.

En effet, pour de tels dispositifs, cette durée peut varier de manière importante suivant que l'on se place dans un cas de temps de décharge moyen de ligne de bit ou dans le pire cas correspondant au critère 6σ.

On cherche donc à réaliser un nouveau dispositif de mémoire SRAM amélioré vis-à-vis d'inconvénients mentionnés ci-dessus.

### EXPOSÉ DE L'INVENTION

Selon un mode de réalisation, la présente invention concerne un dispositif de mémoire statique à accès aléatoire comprenant :
un plan matriciel doté d'au moins une matrice de cellules mémoires SRAM, ladite matrice étant associée à une pluralité de paires de lignes de bits et à une pluralité de lignes de mot, le dispositif étant doté en outre d'un circuit de déclenchement de fin d'opération de lecture, configuré pour émettre un signal Sₑₒᵣ de déclenchement de fin d'opération de lecture indiquant la fin d'une phase donnée d'une opération de lecture effectuée sur la mémoire, cette phase donnée étant elle-même déclenchée par une activation, lors d'une opération de lecture, d'une ligne de mot donnée parmi lesdites lignes de mot, ledit circuit de déclenchement de fin d'opération de lecture comprenant :
- une pluralité de paires de transistors, chaque paire de transistors comportant un premier transistor dont la grille est connectée à une première ligne de bit et un deuxième transistor dont la grille est connectée à une deuxième ligne de bit, complémentaire de la première ligne de bit, les transistors desdites paires ayant chacun une source connectée à un nœud, ledit nœud d'une part et lesdites première et deuxième lignes de bits d'autre part étant, préalablement à l'activation de ladite ligne de mot donnée, respectivement pré-chargés de sorte que le premier transistor et le deuxième transistors sont dans un état de conduction donné, puis, lorsque ladite ligne de mot est activée, lesdites première et deuxième lignes de bits sont déconnectées des moyens de pré-charge, de sorte à modifier l'état de conduction de certains transistors desdites paires de transistors et entrainer en conséquence une variation de potentiel dudit nœud jusqu'à atteindre un potentiel seuil déterminé déclenchant l'émission dudit signal de fin d'opération de lecture.

L'émission de ce signal de fin d'opération est apte à déclencher une activation d'au moins un amplificateur de lecture (SA) qui prélève alors une différence de potentiel entre la première ligne de bit et la deuxième ligne de bit.

Par état de conduction, on entend un état passant ou bloqué. Un exemple de réalisation prévoit que les paires de transistors sont pré-chargées de sorte que les transistors sont tous bloqués avant l'activation de la ligne de mot, puis, après cette ligne de mot progressivement, certains transistors, du circuit de déclenchement deviennent passants.

Le déclenchement de fin lecture mis en œuvre par le biais d'un tel circuit tient compte d'une moyenne statistique des états de toutes les lignes de bits et permet de couvrir les pires cas de temps de décharge correspondant au critère 6σ.

Le premier transistor et le deuxième transistor sont de préférence de même type et de conception identique. Par transistors « de même type », on entend ici le type de conductivité, le premier transistor et le deuxième transistor pouvant être par exemple tous les deux de type PMOS.

Par transistors « de conception identique », on entend que les transistors sont réalisés de manière identique avec une même composition, un même procédé de fabrication et une même géométrie.

Selon une possibilité de mise en œuvre, en particulier lorsque préalablement à l'activation de ladite ligne de mot donnée les lignes de bits sont mis à un potentiel d'alimentation VDD, autrement dit « pré-chargés » au potentiel d'alimentation VDD, le premier transistor et le deuxième transistor peuvent être de type PMOS. Dans ce cas, préalablement à l'activation de ladite ligne de mot donnée, ledit nœud du circuit de détection est typiquement mis (autrement dit « pré-chargé ») à un potentiel de référence (autrement dit de masse) GND.

Le nœud peut être également connecté à une portion de circuit adaptée pour ralentir la variation de potentiel dudit nœud.

Cette portion de circuit peut comprendre une ligne métallique et/ou au moins un condensateur. De la capacité de cette ligne métallique ou du condensateur dépendent le temps de charge ou de décharge du nœud et par conséquent la vitesse à laquelle le potentiel de ce nœud varie avant d'atteindre la valeur de potentiel seuil.

Cette portion de circuit peut également être dotée d'un ou plusieurs transistors de type de conductivité opposée à celle du premier transistor et du deuxième transistor, les autres transistors étant en particulier de type NMOS lorsque le premier et le deuxième transistors sont de type PMOS. De la manière dont ces autres transistors sont configurés, et en particulier de leurs dimensions, dépendent le temps de charge ou de décharge du nœud.

Cette portion de circuit peut être dotée d'un élément de pré-charge supplémentaire comprenant au moins un transistor, l'élément de précharge étant configuré pour appliquer au nœud un potentiel de précharge afin de pré-charger le nœud préalablement à ladite activation de ladite ligne de mot donnée.

Selon une possibilité de mise en œuvre du dispositif, le nœud peut être également connecté à un élément de circuit configuré pour émettre le signal de déclenchement lorsque le potentiel donné dépasse le potentiel seuil. Cet élément de circuit peut être par exemple sous forme d'un inverseur ou d'un comparateur configuré pour comparer ledit potentiel donné à un potentiel de référence.

Selon une possibilité de mise en œuvre du dispositif, une sortie du circuit de déclenchement peut être avantageusement connectée à un circuit de commande adapté pour émettre un signal d'activation dudit amplificateur de lecture consécutivement à la réception dudit signal de déclenchement de fin de lecture.

Selon une possibilité de mise en œuvre du dispositif, une sortie du circuit de déclenchement peut être connectée à un décodeur de lignes configuré pour émettre un signal de désactivation de ligne de mot consécutivement à la réception dudit signal de déclenchement de fin de lecture.

Selon un mode de réalisation particulier dans lequel lesdites première et deuxième lignes de bits sont des lignes de bits locales partagées par des cellules de ladite matrice, le plan mémoire comprend au moins une autre matrice de cellules SRAM, le dispositif peut être doté en outre d'un autre circuit de déclencheur de fin d'opération de lecture, configuré pour émettre un autre signal de déclenchement de fin d'opération de lecture, ledit autre circuit déclencheur étant connecté à d'autres paires de lignes de bits locales partagées par des cellules SRAM de ladite autre matrice. Dans ce cas, un multiplexeur peut être agencé en sortie dudit circuit de déclenchement de fin d'opération de lecture et dudit autre circuit déclencheur de fin d'opération de fin de lecture.

Avantageusement, un circuit de déclenchement tel que mis en œuvre suivant l'invention s'applique particulièrement bien à un dispositif dans lequel les cellules mémoires SRAM sont alimentées par un potentiel d'alimentation VDD bas.

Par « potentiel d'alimentation bas » ou par « basse tension » on entend ici et dans tout la description, une tension qui est inférieure à la moitié d'une tension nominale de fonctionnement qui est généralement établie pour une technologie donnée et dépend donc de la technologie, et en particulier du nœud technologique ITRS de conception de la mémoire. Par exemple pour un dispositif mémoire SRAM mis en œuvre dans un nœud technologique ITRS (pour « International Technology Roadmap for Semiconductors ») inférieur à 32nm on considère par exemple qu'une basse tension est inférieure à 0.6V.

Avantageusement, le circuit de déclenchement s'applique également particulièrement bien à un dispositif dans lequel le potentiel d'alimentation VDD est modulable en fonction du type de mode de fonctionnement (en particulier de lecture, d'écriture ou de rétention) dans laquelle se trouve la mémoire.

Selon un aspect, la présente invention prévoit un procédé de paramétrage d'un dispositif tel que défini précédemment et dans lequel les transistors desdites paires transistors ont une région de canal prévue dans un substrat polarisé selon une polarisation de substrat donnée, le procédé comprenant, après réalisation dudit circuit de déclenchement des étapes consistant à :
- effectuer une opération de lecture sur ladite matrice mémoire puis,
- mesurer la durée de ladite phase donnée lors de cette opération de lecture,
- moduler la polarisation donnée de substrat en fonction de ladite durée mesurée.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre, par le biais d'un chronogramme, différentes phases lors d'une opération de lecture effectuée dans une mémoire SRAM ;
- la figure 2, illustre un exemple d'agencement conventionnel d'une matrice de cellules mémoires SRAM avec des circuits de pré-charge associés ;
- la figure 3 illustre un exemple de cellule mémoire vive statique conventionnelle, susceptible d'être intégrée à un dispositif de SRAM suivant l'invention ;

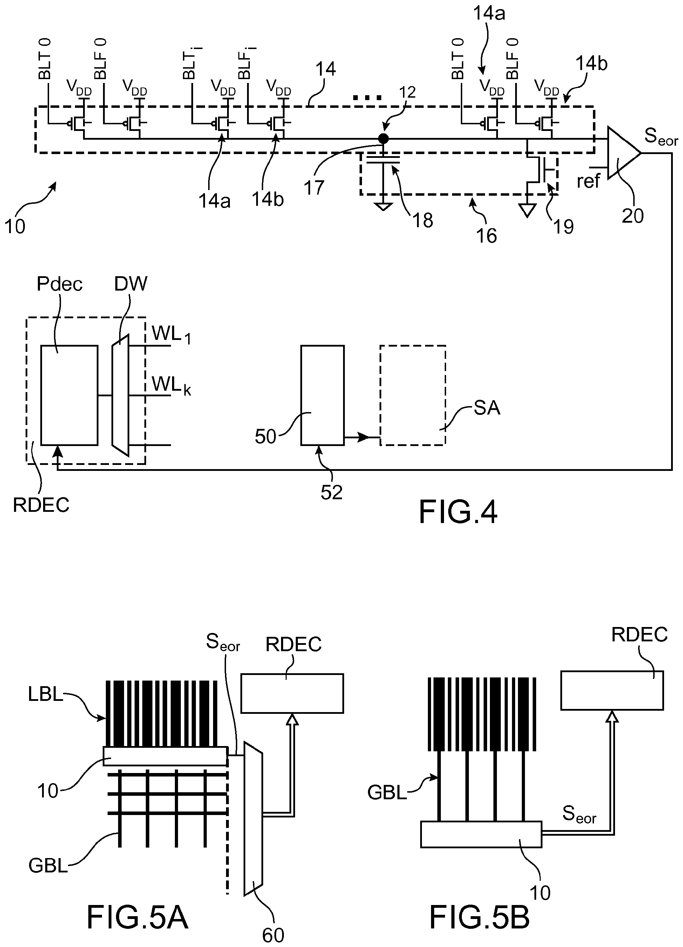

- la figure 4, illustre un exemple de circuit de déclenchement de fin de lecture pour mettre fin à une phase donnée d'opération de lecture correspondant au temps nécessaire pour que la différence de potentiel entre une ligne de bit et une ligne de bit complémentaires, toutes les deux pré-chargées à un même potentiel, atteigne un seuil déterminé suffisant pour permettre de pouvoir activer un amplificateur de lecture chargé de convertir cette différence de tension en un niveau logique représentatif d'une information logique contenue dans une cellule et à laquelle on accède lors d'une opération de lecture ;
- la figure 5A illustre un exemple d'implémentation d'un circuit de déclenchement de fin de lecture tel que mis en œuvre suivant l'invention, connecté à des lignes de bits dites « locales » dans plan matriciel doté de lignes de bits dites « globales », le plan étant partagé en plusieurs groupes ou matrices chacune comportant ses propres lignes de bits « locales » ;
- la figure 5B illustre un autre exemple d'implémentation d'un circuit de déclenchement de fin de lecture tel que mis en œuvre suivant l'invention, connecté à des lignes de bits globales d'un plan matriciel SRAM ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un circuit de déclenchement de fin d'opération de lecture tel que mis en œuvre suivant l'invention est intégré à un dispositif de mémoire SRAM doté d'un plan matriciel comprenant au moins une matrice mémoire, par exemple telle qu'illustrée sur la figure 2, formée d'une pluralité de lignes et de colonnes de cellules mémoires SRAM.

Le circuit de déclenchement peut être implémenté sans modification de la structure interne des cellules C₁₀,...Cᵢₖ,..., Cₙₖ SRAM et ne requiert la mise en œuvre que d'un nombre restreint d'éléments additionnels périphériques au plan mémoire.

Les cellules du dispositif mémoire peuvent avoir un agencement conventionnel tel qu'illustré sur la figure 3.

La cellule Cᵢₖ représentée est dotée de deux nœuds de stockage T et F, prévus pour conserver une première information logique, et une information logique complémentaire de la première information. Le maintien des informations logiques dans les nœuds T, F est assuré par des transistors formant des inverseurs INV1, INV2 bouclés sur eux-mêmes. Par exemple, lorsque la cellule SRAM est de type communément appelé « 6T » et formée ainsi de 6 transistors, les deux inverseurs INV1, INV2, sont typiquement réalisés par deux transistors de charge, par exemple de type PMOS et deux transistors de conduction par exemple de type NMOS. Les inverseurs INV1, INV2 sont dans cet exemple alimentés par un potentiel d'alimentation VDD, qui peut être éventuellement modulé au cours de différentes phases de fonctionnement, en particulier les opérations de lecture, écriture, et phase de rétention du dispositif mémoire.

Le circuit de déclenchement mis en œuvre suivant l'invention s'applique particulièrement bien aux dispositifs mémoires à tension d'alimentation modulable (« supply voltage scaling » selon la terminologie anglo-saxonne) et aux dispositifs mémoires à tension d'alimentation VDD basse, autrement dit inférieure à la moitié d'une tension nominale de fonctionnement.

L'accès aux nœuds de stockage T et F est réalisé par le biais de deux transistors d'accès TA_{T} et TA_{F} connectés respectivement à une première ligne de bit BL_{Ti} et une deuxième ligne de bit BL_{Fi}, complémentaire, partagées par des ou les cellules d'une même colonne COLᵢ de cellules.

Des circuits PC₀, PCₙ de précharge ayant pour rôle de pré-charger les lignes de bits BL_{Ti} et BL_{Fi} à une même valeur donnée de potentiel, par exemple le potentiel d'alimentation VDD sont associés à chaque colonne. Les circuits PC₀, PCₙ de précharge sont typiquement agencés à une extrémité d'une colonne opposée à celle où se trouve un amplificateur de lecture SA (« sense amplifier» selon la terminologie anglo-saxonne) qui reçoit une différence de potentiels entre la ligne de bit et la ligne de bit complémentaire de la cellule à laquelle on accède en lecture et convertit cette différence de potentiels en un signal correspondant à un niveau logique.

L'accès aux nœuds de stockage T et F est permis lorsqu'une ligne de mot WLₖ reliée aux transistors d'accès TA_{T} et TA_{F} et partagée par des ou les cellules SRAM d'une même ligne de cellules de la matrice est activée.

Les transistors d'accès TA_{T} et TA_{F} sont ainsi prévus pour permettre l'accès ou bloquer l'accès respectivement au premier nœud T et au deuxième nœud F. Une opération de lecture sur la cellule Cᵢₖ est déclenchée lorsque la ligne de mot WLₖ est activée, autrement dit qu'un signal émis sur cette dernière permet d'accéder aux nœuds de stockage d'informations des cellules associées à cette ligne de mot WLₖ. La pré-charge des lignes de bits est quant à elle désactivée préalablement à l'activation de la ligne de mot donnée WLₖ.

Ensuite, une fois la ligne de mot WLₖ activée, une phase de l'opération de lecture consiste à attendre qu'une ligne parmi la ligne de bit BLTi et la ligne de bit complémentaire BLFi se décharge.

La durée de cette décharge avant qu'un amplificateur de lecture SA ne soit activé est réglée par l'intermédiaire du circuit de déclenchement d'opération de fin de lecture évoqué précédemment et tel que mis en œuvre suivant l'invention.

Un exemple de réalisation d'un tel circuit 10 est illustré sur la figure 4.

Le circuit 10 de déclenchement est configuré pour générer un signal Sₑₒᵣ indicateur de fin de la phase donnée précitée encore appelé « signal de déclenchement de fin de lecture ». Le circuit 10 de déclenchement est configuré pour permettre de générer ce signal Sₑₒᵣ de déclenchement de fin de lecture en fonction d'une sorte de moyenne statistique de la différence de tension des paires de lignes de bits BLTi, BLFi de la matrice.

Ce circuit 10 de déclenchement est doté d'une première portion 14 de circuit connectée à un nœud 12 dont le potentiel électrique est susceptible, lorsqu'il atteint une valeur seuil prédéterminée, de déclencher l'émission du signal Sₑₒᵣ de déclenchement de fin de lecture.

La première portion 14 de circuit comprend une pluralité de paires de transistors 14a, 14b chaque paire étant reliée à une paire de lignes de bits parmi l'ensemble de lignes de bits et de lignes de bits complémentaires de la matrice.

Les transistors 14a, 14b, sont de même type et de préférence de conception identique. Dans l'exemple de réalisation particulier illustré, les transistors 14a, 14b sont de type PMOS. Chaque paire de transistors comporte un premier transistor 14a dont la grille est connectée à une ligne de bit BLTi parmi les lignes de bits BLTO, BLTn de la matrice de cellules et susceptibles d'être reliées au premier nœud T respectif de cellules de cette matrice.

Chaque paire de transistors comporte également un deuxième transistor 14b donné dont la grille est connectée à une ligne de bit complémentaire BLFi parmi les lignes de bits complémentaires BLFO, BLFn, de la matrice de cellules susceptibles d'être reliés au deuxième nœud F respectif de cellules de cette matrice.

Les transistors 14a, 14b ont une électrode de source connectée au nœud 12.

Dans l'exemple de réalisation illustré, les transistors 14a, 14b ont également un drain connecté à un potentiel de polarisation correspondant ici au potentiel d'alimentation VDD.

Le nœud 12 peut être également relié à une deuxième portion 16 de circuit qui, dans l'exemple de réalisation illustré, est dotée d'au moins un condensateur 18 ou d'une ligne conductrice 17 de capacité 18 prédéterminée.

Au départ de l'opération de lecture, les lignes de bits BLTO, BLTn, BLFO, BLFn sont toutes pré-chargées à un même premier potentiel donné par le biais des circuits de pré-charge PC₀,..., PCn. Dans cet exemple de réalisation, on prévoit une pré-charge des lignes de bits BLTO, BLTn, BLFO, BLFn en leur appliquant par exemple toutes un potentiel d'alimentation VDD.

Dans le même temps, au départ de l'opération de lecture, le nœud 12 est également pré-chargé à un deuxième potentiel, dans cet exemple un potentiel de masse GND. Un élément de pré-charge supplémentaire connecté au nœud 12 peut être ainsi prévu pour appliquer ce deuxième potentiel. Dans l'exemple de réalisation illustré, l'élément de pré-charge appartient à la deuxième portion 16 de circuit connectée au nœud 12 et comporte au moins un transistor 19, par exemple de type NMOS.

Les conditions de pré-charge et potentiels appliqués aux transistors 14a, 14b et au nœud 12 auquel ces transistors 14a, 14b sont connectés sont telles que dans cet exemple de configuration, avant activation d'une ligne de mot WLₖ, permettant de sélectionner une ligne de cellules, les transistors 14a, 14b sont tous dans un état de fonctionnement bloqué. Les lignes de bits BLTO, BLTn, BLFO, BLFn étant toutes placées au même potentiel, l'état de conduction des transistors 14a, 14b est identique et dans cet exemple tel qu'il n'y a pas de circulation de courant entre la première portion 14 de circuit formée par les transistors 14a, 14b et la deuxième portion 16 également connectée au nœud 12.

Puis, lorsque ladite ligne de mot WLₖ est activée, les lignes de bits BLTO, BLTn, BLFO, BLFn sont déconnectées des circuits de pré-charge. Le nœud 12 peut être également déconnecté de son élément de pré-charge associé et laissé flottant. On utilise avantageusement un même signal de pré-charge pour réaliser la pré-charge du nœud 12 et celle des lignes de bits BLTO, BLTn, BLFO, BLFn.

La déconnexion des pré-charges et l'activation de la ligne de mot WLₖ permet ainsi de rendre la tension grille source des transistors 14a, 14b, dépendante notamment des niveaux logiques stockés dans les nœuds des cellules sélectionnées par cette activation et d'entrainer une modification de l'état de conduction de certains transistors de la première portion 14 de circuit. Cette modification peut se produire successivement d'un transistor à l'autre, en fonction des différences de capacités des lignes de bit auxquelles les transistors 14a, 14b sont respectivement associées et des différences liées aux procédés de fabrication entre les cellules qui sont lues dans la matrice.

La modification de l'état de conduction de certains transistors, parmi ladite pluralité de paires de transistors entraine en conséquence une variation du potentiel du nœud 12.

La vitesse à laquelle varie ce potentiel dépend notamment de paramètres de la deuxième portion 16 de circuit, et en particulier de la capacité de la ligne conductrice 17. La deuxième portion 16 de circuit permet ainsi de ralentir une décharge du nœud 12 selon un retard qui peut être réglé, en particulier en fonction de la capacité de la ligne conductrice 17 elle-même dépendante des dimensions que l'on prévoit pour cette la ligne conductrice 17 typiquement formée de métal.

La deuxième portion 16 de circuit peut être également dotée d'un ou plusieurs transistors de type opposé à celui des transistors 14a, 14b, et dont le dimensionnement permet également d'adapter la vitesse à laquelle varie le potentiel du nœud 12. Ainsi, lorsque les transistors 14a, 14b reliés aux lignes de bits, sont de type PMOS, on prévoit de préférence une deuxième portion 16 de circuit avec un ou plusieurs transistors de type NMOS.

Dans l'exemple de réalisation particulier illustré avec le type de précharge qui vient d'être décrit, la deuxième portion 16 de circuit a donc tendance à tirer vers le bas le potentiel au nœud 12 tandis que ce potentiel a tendance à être tiré vers le haut par la mise en conduction de transistors 14a, 14b de la première portion 14 de circuit.

Lorsque le potentiel du nœud 12 atteint un potentiel seuil prédéterminé, l'émission du signal de fin de phase Sₑₒᵣ est déclenchée, par exemple à l'aide d'un inverseur ou comme dans l'exemple illustré, d'un comparateur 20 ayant une entrée connectée au nœud 12 qui est comparée à une autre entrée mise par exemple à un potentiel de référence Vref.

L'émission du signal Sₑₒᵣ de déclenchement de fin d'opération de lecture permet d'activer un amplificateur de lecture SA, lequel reçoit une différence de tension entre les deux lignes de bits de la cellule à laquelle on accède en lecture et convertit cette différence de tension en un signal correspondant à une information logique stockée en mémoire de la cellule qui est lue.

L'activation de l'amplificateur de lecture SA peut être réalisée par exemple par l'intermédiaire d'un signal SA_EN d'activation d'amplificateur de lecture émis par un circuit de commande 50 lorsqu'il reçoit le signal Sₑₒᵣ de déclenchement de fin de lecture.

L'émission du signal Sₑₒᵣ de fin de lecture permet également de déclencher une désactivation, par l'intermédiaire d'un décodeur de ligne RDEC, de la ligne mot WLₖ qui venait d'être activée pour effectuer la lecture. Ainsi, le signal Sₑₒᵣ de déclenchement de fin de lecture peut être émis vers un décodeur de ligne RDEC typiquement formé d'un étage de pré-décodage Pdec et d'un étage pilote de ligne de mot DW. La durée totale de l'opération de lecture dépend également d'une boucle 52 de circuit reliant la sortie du circuit 10 de déclenchement aux moyens d'activation de l'amplificateur de lecture et aux moyens de désactivation de la ligne de mot. Le retard introduit par cette boucle 52 peut être réglé, mais ce réglage n'est pas l'objet de la présente demande.

Comme indiqué précédemment, la durée T_eor de la phase décrite précédemment aboutissant à l'émission du signal Sₑₒᵣ de déclenchement de fin de lecture dépend de la vitesse à laquelle le potentiel du nœud 12 varie à partir du moment où l'on active la ligne de mot.

Une manière d'ajuster cette durée T_eor est d'adapter la taille des transistors 14a, 14b de la première portion 14 de circuit 10. Ces transistors 14a, 14b sont prévus, lors de la conception du dispositif mémoire, avec des dimensions, en particulier un rapport W/L de leur largeur de canal sur leur longueur de canal suffisamment important pour permettre de minimiser les effets dus aux variations aléatoires au sein de la matrice mémoire et suffisamment faible pour pouvoir limiter l'encombrement du circuit 10 de déclenchement.

Afin de pouvoir moduler la durée T_eor de la phase entre l'activation de la ligne de mot et l'activation de l'amplificateur de lecture, une adaptation de la tension de seuil des transistors 14a, 14b peut être également mise en œuvre lors de la conception du dispositif mémoire. On choisit de préférence des transistors 14a, 14b avec des tensions de seuil faibles, par exemple inférieur à 300 mV lorsque la tension d'alimentation est par exemple de l'ordre de 1V.

Comme suggéré précédemment, la durée T_eor peut dépendre également de la deuxième portion 16 de circuit, et en particulier de la capacité de la ligne conductrice 17, elle-même dépendante des dimensions de cette ligne 17, ou bien de la capacité d'au moins un condensateur connecté à cette ligne 17.

Comme suggéré précédemment, dans un cas où la deuxième portion 16 de circuit connectée au nœud 12 comporte un ou plusieurs transistors, par exemple de type NMOS lorsque les transistors 14a, 14b sont de type PMOS, un ajustement de la taille de transistors NMOS de la deuxième portion 16 de circuit permet également de moduler la durée T_eor de la phase précédent le déclenchement de la fin de lecture. Selon un exemple de réalisation particulier, lorsque la première portion 14 est réalisée avec des transistors PMOS et une précharge telle que décrite précédemment, la deuxième portion 16 peut être réalisée avec un ou plusieurs transistors NMOS résistifs c'est à dire avec un rapport W/L faible.

Dans un circuit 10 de déclenchement tel que décrit précédemment on peut également prévoir d'ajuster la polarisation de la couche de substrat (en anglais « body bias ») dans lequel la région de canal des transistors 14a, 14b se trouve en fonction du niveau de tension de polarisation VDD utilisé pour polariser les cellules de la matrice mémoire SRAM.

Cet ajustement ayant pour conséquence d'adapter la tension de seuil des transistors 14a, 14b, il permet également de moduler la durée T_eor de la phase de l'opération de lecture décrite précédemment et conduisant à l'émission du signal Seor de déclenchement de fin de lecture.

Un tel ajustement de la polarisation du substrat et d'adaptation de la tension de seuil des transistors 14a, 14b peut être réalisé une fois que ces transistors 14a, 14b ont été fabriqués. Ainsi, après la fabrication du dispositif mémoire SRAM et du circuit 10 de déclenchement, on peut effectuer un test d'opération de lecture puis, en fonction de la durée de la phase précitée lors de ce test, paramétrer ensuite la polarisation du substrat de manière à réduire la durée de cette phase ou bien augmenter la durée de cette phase.

Dans l'exemple de réalisation particulier de la figure 4, une augmentation de la polarisation de la couche de substrat (body-bias) conduit à une augmentation de la tension de seuil des transistors 14a, 14b ce qui augmente la durée de la phase précédent l'émission du signal Seor, tandis qu'une diminution du body-bias conduit à une baisse de la tension de seuil des transistors 14a, 14b ce qui diminue la durée de la phase précédent l'émission du signal Seor.

Selon une variante de réalisation de celle illustrée pour laquelle les transistors 14a, 14b sont remplacés par des transistors de type NMOS préchargés au potentiel de masse, une augmentation du body-bias conduit à une baisse de la tension de seuil des transistors 14a, 14b ce qui diminue la durée de la phase précédent l'émission du signal Seor.

La mise en œuvre d'une détection de fin de lecture présentée précédemment en lien avec la figure 4 est réalisée avantageusement avec une première portion 14 de circuit dotée de transistors 14a, 14b de type PMOS connectés aux lignes de bits dans la mesure où elle s'adapte particulièrement à une pré-charge des lignes de bits réalisée à une tension d'alimentation VDD et telle que prévue typiquement dans les dispositifs SRAM.

La mise en œuvre d'un circuit de détection du type de celui décrit précédemment avec des transistors 14a, 14b PMOS n'est toutefois pas réservée uniquement à une pré-charge des lignes de bits au potentiel d'alimentation VDD.

Une autre variante de réalisation peut prévoir des lignes de bits BLTO, BLTn,..., BLFO, BLFn initialement mises à un potentiel de masse ou de référence GND avant qu'une ligne de mot ne soit activée. Dans ce cas, le nœud 12 est quant à lui placé initialement à un potentiel, par exemple d'alimentation égal à VDD, de sorte qu'avant activation de ligne de mot, tous les transistors 14a, 14b soient dans un état conducteur. Puis lorsqu'une ligne de mot est activée, certains transistors parmi les paires de transistors 14a, 14b deviennent progressivement bloqués. Dans ce cas de figure, on peut détecter lorsque le nœud 12 passe au-dessous d'une valeur seuil déclenchant l'émission du signal Seor permettant d'activer un amplificateur de lecture et une désactivation de la ligne de mot.

On peut prévoir en variante un circuit 10 comportant une première portion 14 dotée de transistors 14a, 14b de type NMOS, notamment si l'on souhaite mettre en œuvre une précharge des lignes de bits BLTO, BLTn BLFO, BLFn à un potentiel de masse ou de référence GND. Le nœud 12 peut être dans ce cas pré-chargé au potentiel d'alimentation VDD. La deuxième portion 16 de circuit peut être pourvue d'un ou plusieurs transistors de type opposé à celui des transistors 14a, 14b, en particulier un ou plusieurs transistors PMOS lorsque les transistors 14a, 14b, sont de type NMOS. Cela permet de contrebalancer la variation de potentiel au nœud 12 une fois que la ligne de mot est activée. Dans cet exemple de réalisation, la deuxième portion 16 de circuit a donc tendance à tirer vers le haut le potentiel au nœud 12 tandis que ce potentiel a tendance à être tiré vers le bas par la première portion 14 de circuit.

Ainsi, après activation de la ligne de mots, le potentiel du nœud 12 a tendance à baisser jusqu'à atteindre une valeur seuil déclenchant l'émission du signal Seor.

La détection du passage en dessous de la valeur seuil peut être réalisée par le biais d'un circuit de type inverseur ou comparateur ayant une tension de référence programmable.

La mise en œuvre de la première portion 14 de circuit 10 de détection avec des transistors NMOS n'est pas réservée uniquement à une pré-charge des lignes de bits au potentiel de référence GND.

Une autre variante de réalisation peut prévoir des lignes de bits BLTO, BLTn,..., BLFO, BLF initialement préchargées à un potentiel d'alimentation VDD tandis que le nœud 12 peut être placé à la masse. Les transistors 14a, 14b de la première portion 14 de circuit sont dans ce cas initialement tous conducteurs puis lorsqu'une ligne de mot est activée, certains transistors changent d'état de conduction et deviennent bloqués.

Un mode de réalisation particulier lorsque la première portion 14 de circuit est formée de transistors 14a, 14b, de type NMOS, prévoit de mettre en série ces transistors chacun avec un transistor de même type monté en diode, autrement dit avec son électrode de grille et son drain connectés afin de pouvoir délivrer un courant plus important.

Une autre manière d'ajuster la durée de la phase précitée et en particulier de retarder est de laisser l'élément de précharge et en particulier le transistor 19 actif, une fois la ligne de mot rendue active. Dans ce cas, on prévoit de préférence une boucle de rétroaction afin d'utiliser le signal de déclenchement pour désactiver ce transistor lorsque le potentiel au nœud 12 atteint la valeur seuil désirée.

Une autre manière d'ajuster la durée de la phase précitée conduisant à l'émission du signal Sₑₒᵣ est d'adapter le nombre de lignes de bits auxquelles le circuit 10 de déclenchement est connecté.

Un circuit 10 de déclenchement suivant l'invention peut être intégré à dispositif mémoire doté d'un plan matriciel divisé en plusieurs matrices ou groupe de cellules mémoires SRAM, chaque matrice ou groupe de cellules mémoires SRAM comprenant des lignes de bit locales LBL connectées à chacune des cellules de mémoire dans le groupe de cellules de mémoire. Chaque matrice ou groupe est également associé à une ou plusieurs lignes de bits globales GBL.

Dans l'exemple de réalisation illustré sur la figure 5A, on prévoit un circuit de déclenchement 10 du type de celui décrit précédemment associé à une matrice de cellules et connecté à des lignes de bits locales LBL.

D'autres circuits de déclenchement du même type peuvent être également prévus en sortie respectivement d'autres matrices (non-représentées). Le signal de déclenchement de fin de lecture Sₑₒᵣ en sortie d'un circuit 10 de déclenchement peut être dans ce cas transmis à un multiplexeur 60 dont des entrées sont connectées respectivement aux différentes sorties des différents circuits de déclenchement et aptes chacun à délivrer un signal de déclenchement de fin de lecture.

Un autre exemple de réalisation, illustré sur la figure 5B, prévoit un circuit de déclenchement 10 du type de celui décrit précédemment connecté à des lignes de bits globales GBL d'un plan matriciel divisé en plusieurs matrices et muni de lignes de bits locales et de lignes de bits globales.

Un test de simulation comparatif a été effectué entre un premier type d'implémentation correspondant à un dispositif du type de celui illustré sur la figure 5A et comportant 128 lignes de bits locales et 32 lignes de bits globales pour des mots 32 bits, et un deuxième type d'implémentation correspondant à un dispositif du type de celui illustré sur la figure 5B avec 32 lignes de bits globales pour des mots de 32 bits. Le circuit de déclenchement 10 est prévu avec des dimensions identiques d'une implémentation à l'autre de sorte que les capacités parasites de ce circuit sont comparables entre les deux types implémentations.

La variance σT_EOR de la durée T_EOR de phase aboutissant à l'émission du signal de fin de lecture, pour un même temps de décharge total T_BL des lignes de bits BL, est deux fois plus faible, par exemple de l'ordre de 0.6 ns, pour le premier type d'implémentation que pour le deuxième type d'implémentation. La durée T_EOR est également plus faible pour le premier type d'implémentation. En effet, pour le premier type d'implémentation, le circuit de déclenchement prend en compte un nombre de lignes de bits plus élevé.

Un dispositif de mémoire SRAM tel que décrit précédemment et pourvu d'un circuit de déclenchement permettant d'optimiser le déclenchement d'une fin d'opération de lecture peut être avantageusement pourvu d'un circuit interne de correction d'erreur de code ECC (pour « Error Correction Code »).

Selon un mode de réalisation particulier, un circuit de déclenchement de fin d'opération de lecture tel qu'évoqué précédemment peut être associé à une structure de circuit dotée de lignes de bits factices reliées à des colonnes de cellules factices (en anglais « dummy cells ») et permettant également de déclencher la fin d'opération de lecture.

On pourra prévoir de sélectionner, par exemple par l'intermédiaire d'une broche externe au dispositif mémoire ou par le biais d'un circuit de sélection interne au dispositif mémoire, le circuit de déclenchement de fin d'opération de lecture suivant l'invention ou celui utilisant une colonne factice. Un tel circuit utilisant une colonne factice est décrit par exemple dans le document « Low Power and Reliable SRAM Memory Cell and Array Design », de Ishibashi et al, Springer Series in Advanced Micro-electronics, 2011.

La sélection peut être opérée en fonction du niveau de tension d'alimentation utilisé. On peut par exemple prévoir de sélectionner le circuit de déclenchement de fin d'opération de lecture tel que mis en œuvre suivant l'invention lorsque la tension d'alimentation appartient à une première gamme de tension d'alimentation et sélectionner le circuit de déclenchement à colonne factice lorsque la tension d'alimentation utilisée est plus élevée que celles de la première gamme.

## Revendications

1. Dispositif de mémoire statique à accès aléatoire comprenant : un plan matriciel d'au moins une matrice de cellules (C₁₁, C_{N1}) mémoires SRAM, ladite matrice étant associée à une pluralité de paires de lignes de bits (BL_{T0}, BL_{F0},..., BL_{Tn}, BL_{Fn}) et à une pluralité de lignes de mot (WL₁..,WLₖ..), le dispositif étant doté en outre d'un circuit (10) de déclenchement de fin d'opération de lecture, configuré pour émettre un signal (Seor) de déclenchement de fin d'opération de lecture indiquant la fin d'une phase donnée d'une opération de lecture effectuée sur la mémoire, cette phase donnée étant elle-même déclenchée par une activation, lors d'une opération de lecture, d'une ligne de mot (WLk) donnée parmi lesdites lignes de mot, ledit circuit (10) de déclenchement de fin d'opération de lecture comprenant :
- une pluralité de paires de transistors (14a, 14b) chaque paire de transistors ayant un premier transistor (14a) dont la grille est connectée à une première ligne de bit (BL_{Ti}) et un deuxième transistor (14b) dont la grille est connectée à une deuxième ligne de bit, complémentaire (BL_{Fi}) de la première ligne de bit, les transistors desdites paires ayant chacun une source connectée à un nœud (12), le premier transistor (14a) et le deuxième transistor (14b) étant des transistors de même type et de préférence de conception identique, ledit nœud (12) et lesdites première et deuxième lignes de bits étant, préalablement à l'activation de ladite ligne de mot donnée, respectivement préchargés de sorte que le premier et le deuxième transistors sont dans un état de conduction donné, puis, lorsque ladite ligne de mot est activée, lesdites première et deuxième lignes de bits sont déconnectés des moyens de pré-charge, de sorte à modifier l'état de conduction de certains transistors desdites paires de transistors et entrainer en conséquence une variation de potentiel dudit nœud jusqu'à atteindre un potentiel seuil déterminé déclenchant l'émission du signal de fin de phase (Seor), le signal de fin de phase (Seor) étant apte à déclencher une activation d'au moins un amplificateur de lecture (SA) connecté auxdites première et deuxième lignes de bits.

2. Dispositif selon la revendication 1, dans lequel le premier transistor (14a) et le deuxième transistor (14b) sont des transistors de type PMOS, dans lequel les lignes de bits sont, préalablement à l'activation de ladite ligne de mot donnée, préchargées à un potentiel d'alimentation VDD, le nœud (12) du circuit de détection étant pré-chargé à un potentiel de masse GND.

3. Dispositif selon l'une des revendications 1 ou 2, dans lequel le nœud (12) est connecté à une portion (16) de circuit adaptée pour ralentir ladite variation de potentiel dudit nœud, ladite portion (16) de circuit comprenant un ligne métallique (17) et/ou au moins un condensateur (18).

4. Dispositif selon la revendication 3, dans lequel ladite portion (16) de circuit comprend un ou plusieurs autres transistors de type opposé au premier transistor (14a) et au deuxième transistor (14b), les autres transistors étant avantageusement de type NMOS lorsque le premier transistor (14a) et le deuxième transistor (14b) sont des transistors de type PMOS.

5. Dispositif selon l'une des revendications 3 ou 4, dans lequel ladite portion de circuit comprend un élément de pré-charge doté d'un ou plusieurs transistors (19), l'élément de précharge étant configuré pour appliquer au nœud un potentiel de précharge préalablement à ladite activation de ladite ligne de mot donnée.

6. Dispositif selon l'une des revendications 1 à 5, dans lequel le nœud (12) est connecté à un élément de circuit, tel qu'un comparateur (20) ou un inverseur, configuré pour émettre ledit signal de déclenchement de fin de lecture (Sₑₒᵣ) lorsque le potentiel seuil est atteint ou dépassé.

7. Dispositif selon l'une des revendications 1 à 6, dans lequel une sortie du circuit (10) de déclenchement est connectée à un circuit de commande (50) adapté pour émettre un signal d'activation (SA_EN) dudit amplificateur de lecture consécutivement à la réception dudit signal de déclenchement de fin de lecture.

8. Dispositif selon l'une des revendications 1 à 7, dans lequel une sortie du circuit de déclenchement est connectée à un décodeur de lignes (RDEC) configuré pour émettre un signal de désactivation de ligne de mot consécutivement à la réception dudit signal de déclenchement de fin de lecture.

9. Dispositif de mémoire selon l'une des revendications 1 à 8, dans lequel lesdites première et deuxième lignes de bits (BL_{T0}, BL_{F0},..., BL_{Tn}, BL_{Fn}) sont des lignes de bits (BL_{T0}, BL_{F0},..., BL_{Tn}, BL_{Fn}) locales partagées par des cellules de ladite matrice, le plan mémoire comprend au moins une autre matrice de cellules SRAM, le dispositif étant doté en outre :
- d'un autre circuit (10) déclencheur de fin d'opération de lecture, configuré pour émettre un autre signal (Seor) de déclenchement de fin d'opération de lecture, ledit autre circuit déclencheur étant connecté à d'autres paires de lignes de bits (BL_{T0}, BL_{F0},..., BL_{Tn}, BL_{Fn}) locales partagées par des cellules SRAM de ladite autre matrice,
- d'un multiplexeur en sortie dudit circuit de déclenchement de fin d'opération de lecture et dudit autre circuit déclencheur de fin d'opération de fin de lecture.

10. Dispositif de mémoire statique selon l'une des revendications 1 à 9, dans lequel les cellules (C₁₁, C_{N1}) mémoires SRAM sont alimentées par une tension d'alimentation VDD basse ou qui est modulable en fonction du type de mode, de lecture, écriture ou rétention dans laquelle se trouve la mémoire.

11. Procédé de paramétrage d'un dispositif selon l'une des revendications 1 à 10, dans lequel les transistors desdites paires transistors (14a, 14b) ont une région de canal prévue dans un substrat polarisé selon une polarisation de substrat donnée, le procédé comprenant, après réalisation ou fabrication dudit circuit de déclenchement des étapes consistant à :
- effectuer une opération de lecture sur ladite matrice mémoire puis,
- mesurer la durée de ladite phase donnée lors de cette opération de lecture,
- moduler la polarisation donnée de substrat en fonction de ladite durée mesurée.

## Patentansprüche

1. Statische Speichervorrichtung mit wahlfreiem Zugriff, umfassend: eine Matrixebene mit wenigstens einer Matrix von SRAM-Speicherzellen (C₁₁, C_{N1}), wobei die Matrix einer Mehrzahl von Paaren von Bitleitungen (BL_{TO}, BL_{FO}, ..., BL_{Tn}, BL_{Fn}) und einer Mehrzahl von Wortleitungen (WL₁.., WLₖ..) zugeordnet ist,
wobei die Vorrichtung ferner mit einer Schaltung (10) zur Auslösung des Endes der Leseoperation versehen ist, die dazu konfiguriert ist, ein Signal (Seor) zur Auslösung des Endes der Leseoperation zu emittieren, das das Ende einer gegebenen Phase einer Leseoperation angibt, die auf dem Speicher ausgeführt wird, wobei diese gegebene Phase selbst wiederum durch eine Aktivierung, während einer Leseoperation, einer gegebenen Wortleitung (WLk) aus den Wortleitungen ausgelöst wird, wobei die Schaltung (10) zur Auslösung des Endes der Leseoperation umfasst:
- eine Mehrzahl von Paaren von Transistoren (14a, 14b), wobei jedes Paar von Transistoren einen ersten Transistor (14a) hat, dessen Gate mit einer ersten Bitleitung (BL_{Ti}) verbunden ist, und einen zweiten Transistor (14b), dessen Gate mit einer zweiten, zur ersten Bitleitung komplementären Bitleitung (BL_{Fi}) verbunden ist, wobei die Transistoren der Paare jeweils eine Source haben, die mit einem Knoten (12) verbunden ist, wobei der erste Transistor (14a) und der zweite Transistor (14b) Transistoren vom gleichen Typ und vorzugsweise mit der gleichen Gestaltung sind, wobei der Knoten (12) und die ersten und zweiten Bitleitungen vor der Aktivierung der gegebenen Wortleitung jeweils derart vorgeladen werden, dass der erste und der zweite Transistor in einem gegebenen Leitungszustand sind, und dann, wenn die Wortleitung aktiviert wird, die erste und die zweite Bitleitung von den Vorlademitteln getrennt werden, derart, dass der Leitungszustand von bestimmten Transistoren von den Paaren von Transistoren modifiziert wird und als Konsequenz eine Variation des Potentials des Knotens bewirkt wird, bis ein bestimmtes Schwellenpotential erreicht wird, das die Emission des Phasenendsignals (Seor) auslöst, wobei das Phasenendsignal (Seor) dazu ausgelegt ist, eine Aktivierung wenigstens eines Leseverstärkers (SA) auszulösen, der mit der ersten und der zweiten Bitleitung verbunden ist.

2. Vorrichtung nach Anspruch 1, bei der der erste Transistor (14a) und der zweite Transistor (14b) Transistoren vom Typ PMOS sind, wobei die Bitleitungen vor der Aktivierung der gegebenen Wortleitung auf ein Versorgungspotential VDD vorgeladen werden, wobei der Knoten (12) der Detektionsschaltung auf ein Massepotential GND vorgeladen wird.

3. Vorrichtung nach einem der Ansprüche 1 oder 2, bei der der Knoten (12) mit einem Bereich (16) der Schaltung verbunden ist, der dazu ausgelegt ist, die Variation des Potentials des Knotens zu verlangsamen, wobei der Bereich (16) der Schaltung eine metallische Leitung (17) und/oder wenigstens einen Kondensator (18) umfasst.

4. Vorrichtung nach Anspruch 3, bei der der Bereich (16) der Schaltung einen oder mehrere andere Transistoren eines Typs entgegengesetzt zu dem ersten Transistor (14a) und zum zweiten Transistor (14b) umfasst, wobei die anderen Transistoren vorzugsweise vom Typ NMOS sind, wenn der erste Transistor (14a) und der zweite Transistor (14b) Tarnsistoren vom Typ PMOS sind.

5. Vorrichtung nach einem der Ansprüche 3 oder 4, bei der der Bereich der Schaltung ein Vorladeelement umfasst, das mit einem oder mehreren Transistoren (19) ausgestattet ist, wobei das Vorladeelement dazu konfiguriert ist, an den Knoten ein Vorladepotential vor der Aktivierung der gegebenen Wortleitung anzulegen.

6. Vorrichtung nach einem der Ansprüche 1 bis 5, bei der der Knoten (12) mit einem Schaltungselement wie zum Beispiel einem Komparator (20) oder einem Inverter verbunden ist, das dazu konfiguriert ist, das Signal zur Auslösung des Leseendes (Sₑₒᵣ) zu emittieren, wenn das Schwellenpotential erreicht oder überschritten wird.

7. Vorrichtung nach einem der Ansprüche 1 bis 6, bei der ein Ausgang der Schaltung (10) zur Auslösung verbunden ist mit einer Steuerschaltung (50), die dazu ausgelegt ist, ein Signal zur Aktivierung (SA_EN) des Leseverstärkers im Anschluss an den Empfang des Signals zur Auslösung des Leseendes zu emittieren.

8. Vorrichtung nach einem der Ansprüche 1 bis 7, bei der ein Ausgang der Auslöseschaltung mit einem Leitungsdecoder (RDEC) verbunden ist, der dazu konfiguriert ist, ein Signal zur Deaktivierung der Wortleitung im Anschluss an den Empfang des Signals zur Auslösung des Leseendes zu emittieren.

9. Speichervorrichtung nach einem der Ansprüche 1 bis 8, bei der die ersten und zweiten Bitleitungen (BL_{T0}, BL_{F0}, ..., BL_{Tn}, BL_{Fn}) lokale Bitleitungen (BL_{T0}, BL_{F0}, ..., BL_{Tn}, BL_{Fn}) sind, die durch die Zellen der Matrix geteilt werden, wobei die Speicherebene wenigstens eine andere Matrix von SRAM-Zellen umfasst, wobei die Vorrichtung ferner versehen ist:
- mit einer anderen Schaltung (10) zur Auslösung des Endes der Leseoperation, die dazu konfiguriert ist, ein anderes Signal (Seor) zur Auslösung des Endes der Leseoperation zu emittieren, wobei die andere Auslöseschaltung verbunden ist mit anderen Paaren von lokalen Bitleitungen (BL_{T0}, BL_{F0}, ..., BL_{Tn}, BL_{Fn}), die durch die SRAM-Zellen der anderen Matrix geteilt werden,
- mit einem Multiplexer am Ausgang der Schaltung zur Auslösung des Endes der Leseoperation und der anderen Schaltung zur Auslösung des Endes der Leseoperation.

10. Statische Speichervorrichtung nach einem der Ansprüche 1 bis 9, bei der die SRAM-Speicherzellen (C₁₁, C_{N1}) mit einer Versorgungsspannung VDD versorgt werden, die niedrig oder modulierbar ist als Funktion des Typs des Modus, des Lesens, des Schreibens oder des Haltens, in dem sich der Speicher befindet.

11. Verfahren zur Parametrisierung einer Vorrichtung nach einem der Ansprüche 1 bis 10, bei dem die Transistoren der Transistorpaare (14a, 14b) eine Kanalregion haben, die vorgesehen ist in einem Substrat, das gemäß einer gegebenen Substratpolarisation polarisiert ist, wobei das Verfahren nach der Realisierung oder Herstellung der Auslöseschaltung die folgenden Schritte umfasst:
- Ausführen einer Leseoperation auf der Speichermatrix, und dann
- Messen der Dauer der gegebenen Phase während dieser Leseoperation,
- Modulieren der gegebenen Polarisation des Substrats als Funktion der gemessenen Dauer.

## Claims

1. A static random access memory device comprising: an array plane of at least one array of SRAM memory cells (C₁₁ Cₙ₁), said array being associated with a plurality of pairs of bit lines (BL_{TO}, BL_{TO},..., BL_{Tn}, BL_{Fn}) and with a plurality of word lines (WL₁..,WLₖ)
the device further being provided with a circuit (10) for triggering the end of the read operation, configured for emitting a signal (Seor) for triggering the end of the read operation indicating the end of a given phase of a read operation carried out on the memory, with this given phase being itself triggered by an activating, during a read operation, of a given word line (WLk) among said word lines, said circuit (10) for triggering the end of the read operation comprising:
- a plurality of pairs of transistors (14a, 14b) each pair of transistors having a first transistor (14a) of which the gate is connected to a first bit line (BL_{Ti}) and a second transistor (14b) of which the gate is connected to a second bit line (BL_{Fi}), complementary to the first bit line, the transistors of said pairs with each one having a source connected to a node (12), the first transistor (14a) and the second transistor (14b) being of the same type and preferably of identical design, said node and said first and second bit lines being, prior to the activation of said given word line, respectively precharged in such a way that the first and second transistors are in a given conduction state, then, when said word line is activated, said first and second bit lines are disconnected from the pre-charging means, in such a way as to modify the conduction state of certain transistors of said pairs of transistors and consequently cause a variation in the potential of said node until reaching a determined threshold potential that triggers the emission of an end-of-phase signal (Seor), the end-of phase signal being able to trigger an activating of at least one sense amplifier (SA) connected to said first and second bit lines.

2. The static random access memory device according to claim 1, wherein the first transistor (14a) and the second transistor (14b) are transistors of the PMOS type, wherein the bit lines are, prior to the activation of said given word line, precharged to a supply potential VDD, the node (12) of the detection circuit being precharged to a ground potential GND.

3. The static random access memory device according to any of the claims 1 or 2, wherein the node (12) is connected to a circuit portion (16) adapted to slow down said variation in potential of said node, said circuit portion (16) comprising a metal line (17) and/or at least one capacitor (18).

4. The static random access memory device according to claim 3, wherein said circuit portion (16) comprises one or several other transistors of the type opposite the first transistor (14a) and opposite the second transistor (14b), the other transistors advantageously being of the NMOS type when the first transistor (14a) and the second transistor (14b) are transistors of the PMOS type.

5. Device according to any of the claims 3 or 4, wherein said circuit portion comprises a pre-charging element provided with one or several transistors (19), the pre-charging element being configured to apply to the node a pre-charge potential prior to said activating of said given word line.

6. Device according to any of the claims 1 to 5, wherein the node (12) is connected to a circuit element, such as a comparator (20) or an inverter, configured to emit said end-of-reading triggering signal (Sₑₒᵣ) when the threshold potential is reached or exceeded.

7. Device according to any of the claims 1 to 6, wherein an output of the triggering circuit is connected to a control circuit adapted to emit an activation signal of said sense amplifier consecutive to the receiving of said end-of-reading triggering signal.

8. Device according to any of the claims 1 to 7, wherein an output of the triggering circuit is connected to a line decoder configured to emit a word line deactivation signal consecutive to the receiving of said end-of-reading triggering signal.

9. Device according to any of the claims 1 to 8, wherein said first and second bit lines (BL_{TO}, BL_{TO},..., BL_{Tn}, BL_{Fn}) are local bit lines (BL_{TO}, BL_{FO},..., BL_{Tn}, BL_{Fn}) shared by cells of said array, the memory plane comprising at least one other SRAM cell array, the device further being provided:
- with another circuit (10) for triggering the end of the read operation, configured to emit another signal (Seor) for triggering the end of the read operation, said other triggering circuit being connected to other pairs of local bit lines (BL_{TO}, BL_{TO},..., BL_{Tn}, BL_{Fn}) shared by SRAM cells of said other array,
- with a multiplexer at the output of said circuit for triggering the end of the read operation and of said other triggering circuit of the end of the operation of the end of reading.

10. Device according to any of the claims 1 to 9, wherein the SRAM memory cells (C₁₁ C_{N1}), are powered by a low supply voltage VDD or which can be scaled according to the type of mode, reading, writing or retaining in which the memory is.

11. A Method for configuring a device according to any of the claims 1 to 10, wherein the transistors of said pairs of transistors (14a, 14b) have a channel region provided in a biased substrate according to a given substrate biasing, the method comprising, after production or manufacturing of said triggering circuit steps consisting in:
- carrying out a read operation on said memory array then,
- measuring the duration of said given phase during this read operation,
- scaling the given substrate biasing according to said measured duration.
